# EUROPEAN PATENT APPLICATION

(11) **EP 2 042 880 A2**
(43) Date of publication of application: **01.04.2009**
(21) Application number: 08165348.7
(22) Date of filing: 29.09.2008
(51) Int. Cl.: G01R 31/42

(54) **Method and apparatus for diagnosing inverter linkages**

(30) Priority: 28.09.2007 US 864179
(71) Applicant: Rockwell Automation Technologies, Inc., Mayfield Heights, OH 44124 (US)
(72) Inventor: McGuire, Jeffrey D., Franklin, WI 53132 (US); Braun, Dennis H., Brookfield, WI 53005 (US); Straw, William D., Hales Corners, WI 53130 (US)
(74) Representative: Grünecker, Kinkeldey, Stockmair & Schwanhäusser Anwaltssozietät

(57) **Abstract**

A method for diagnosing the linkages of an inverter including a controller connected to switching devices that are between a DC input and a multi-phase output. The inverter can be diagnosed to determine whether the control signals provided to the switching devices are being properly provided to the inverter and whether the inverter is operating properly. Diagnosis of the inverter is advisable upon commissioning or after completion of a repair. The controller can provide at least one signal to the switching devices and the signal can be monitored adjacent to the switching devices to ensure that the switching devices are receiving the correct signals from the controller. The controller can provide at least one signal to the switching devices and the output of the inverter can be monitored to determine whether the inverter operates in accordance with the provided signal.

## Description

### CROSS-REFERENCE TO RELATED APPLICATIONS

Not applicable.

### STATEMENT REGARDING FEDERALLY SPONSORED RESEARCH OR DEVELOPMENT

Not applicable.

### BACKGROUND OF THE INVENTION

The present invention relates to inverters with a controller connected to switching devices that are between a DC input and a multi-phase output and more specifically to an apparatus and method for diagnosing inverter linkages.

Power plants are linked to power consuming facilities (e.g., buildings, factories, etc.) via utility grids designed so as to be extremely efficient in delivering large amounts of power. To facilitate efficient distribution, power is delivered over long distances as low frequency three-phase AC current. Despite being distributable efficiently, low frequency AC current is sometimes not suitable for end use in consuming facilities. Thus, prior to end use, power delivered by a utility has to be converted to a usable form. To this end, a typical power "conditioning" configuration includes an AC-to-DC rectifier that converts the utility AC power to DC across positive and negative DC buses (i.e., across a DC link) and an inverter linked to the DC link that converts the DC power back to three-phase AC power having an end-useable form (e.g., three-phase relatively high frequency AC voltage). A controller controls the inverter in a manner calculated to provide voltage waveforms required by the consuming facility. Typically, an inverter includes a plurality of switches that can be controlled to link and delink the positive and negative DC buses to motor supply lines. The linking/delinking sequence causes voltage pulses on the motor supply lines that together define alternating voltage waveforms.

A typical three phase inverter structure includes six switching devices (e.g., IGBTs) that are arranged between positive and negative DC buses of a rectifier apparatus to form first, second and third switch legs where each leg includes a pair of switches. The first leg includes first and second switches arranged in series, the second leg includes third and fourth switches in series and the third leg includes fifth and sixth switches where nodes between each switch pair are linked to different phases of a three phase load. The above topology is generally referred to as a single inverter structure. By controlling the switching cycles of the six switches the DC voltage across the DC buses is converted into three phase AC voltage that is delivered to the load.

Due to the configuration of the voltage source inverter switches, one of the two switches in each switch leg must block voltage while the other switch in the switch leg conducts or an inverter fault will occur. If both switches in the same switch leg conduct at the same time, a high current surge will occur cause a catastrophic device failure. Therefore, it is extremely important that the switches in each leg are not turned on at the same time.

During commissioning and initial power up of an inverter or after an inverter has been repaired, it is important to ensure that inverter linkages are connected properly before commencing normal inverter operation. In the past, there was no way to test the inverter other than to simply power up the system at operational capacity and see if the device worked as expected or failed catastrophically.

Simply activating the inverter at full power was not an acceptable method of diagnosing the inverter because the inverter could fail at a later time even when a failure did not immediately occur upon startup. Accordingly, a less risky method diagnosing the inverter was developed. To verify that the inverter linkages are connected properly and that the inverter can support the full DC bus voltage, a separate lower voltage DC supply was provided to the inverter prior to normal operation of the inverter. With the lower voltage DC supply connected, the switches can be operated by the controller at the normal switching frequencies while minimizing the risk of a catastrophic current surge. If the inverter linkages are not connected properly and two switches in the same leg are turned on at the same time, the current surge produced may not be destructive due to the lower voltage DC supply. Upon commissioning or after a repair in the field, connecting a separate DC supply can be extremely impractical if not impossible. Additionally, testing the inverter with a low voltage supply does not test the ability of the switching devices to handle the commutations at higher voltages and currents. Moreover, the method identifies that there is a problem with the inverter but does not pinpoint the source of the problem because it is often too difficult to diagnose the inverter during high frequency operation.

Thus, it would be advantageous to have a method for diagnosing inverter linkages that minimizes the risk of creating a damaging current surge, does not require a separate lower voltage DC supply, and provides information about the source of a problem with the inverter linkages.

### BRIEF SUMMARY OF THE INVENTION

At least some inventive embodiments provide a method for diagnosing inverter linkages during a diagnostic procedure prior to normal inverter control. The method can be used with inverters having an inverter controller and a set of inverter switching devices, the inverter switching devices including at least first and second switching devices and inverter output lines, each switching device including a gate terminal, the controller linked to each gate terminal to control each switching device independently. The method comprising the steps of providing a display device for displaying at least one signal waveform, coupling one of a voltage sensor to the gate terminal of the first switching device and a current sensor to the inverter output line associated with the first switching device, the sensor generating a sensor signal, using the inverter controller to provide a first gate turn on signal to the first switching device and presenting the sensor signal via the display device for observation by a user.

The method can further include the step of using the inverter controller to provide a second gate turn on signal to the second switching device where the first and second turn on signals are provided to the first and second switching devices simultaneously. The inverter can include at least first and second poles, each pole including a pair of switching devices linked in series between positive and negative DC buses, the switches in each pair linked at a common node to one of the inverter output lines, the first and second poles including the first and second switching devices, the first switching device linked to one of a positive DC bus and a negative DC bus and the second switching device linked to the other of the positive and the negative DC buses. Furthermore, the step of coupling one of a voltage sensor and a current sensor can include coupling a first current sensor to a first inverter output line associated with the first inverter switching device so that the first current sensor generates a first sensor current signal.

Moreover, the method can further include the steps of coupling a second current sensor to a second inverter output line so that the second current sensor generates a second sensor current signal and presenting the second sensor current signal via the display device for observation by a user, the first and second sensor current signals presented simultaneously. Additionally, the method can include the step of comparing the presented sensor current signals to anticipated current signals. The step of using the inverter controller to provide the first gate turn on signal can include using the controller to provide a first sequence of gate turn on signals to the first switching device. The step of using the inverter controller to provide the second gate turn on signal can include using the controller to provide a second sequence of gate turn on signals to the second switching device. Each of the first and second sequences can include at least two turn on signals.

The step of coupling one of a voltage sensor and a current sensor can include coupling a voltage sensor to the gate terminal of the first switching device. The step of using the inverter controller to provide a first gate turn on signal to the first switching device can include using the controller to provide a first gate turn on signal having a predetermined pulse width. The step of using the inverter controller to provide a first gate turn on signal to the first switching device can further include using the controller to provide a second gate turn on signal to the first switching device that has a predetermined pulse width and that is separated from the first gate turn on signal by a predetermined interval.

Additionally, the step of using the inverter controller to provide a first gate turn on signal to the first switching device can further include using the controller to provide a separate gate turn on signal to each of the inverter switching devices in a consecutive sequence.

Other embodiments include a method for use with an inverter and an inverter controller during a diagnostic procedure prior to normal inverter control. The inverter can include a set of inverter switching devices including at least first, second, third and fourth switching devices and inverter output lines, each switching device including a gate terminal, the controller linked to each gate terminal to control each switching device independently. The method can comprise the steps of providing a display device for displaying at least one signal waveform, coupling a voltage sensor to the inverter at a location electrically linked to the gate terminal of a first switching device, the sensor generating a voltage sensor signal, using the inverter controller to provide a first gate turn on signal to the first switching device, and presenting the voltage sensor signal via the display device for observation by a user. The inverter can include at least first and second poles, the first pole including the first and second switching devices linked in series between a positive DC bus and a negative DC bus and linked at a common coupling point to a first of the inverter output lines and the second pole including the third and fourth switching devices linked in series between the positive and negative DC buses and linked at a common coupling point to a second of the inverter output lines, the first and third switching devices linked to the positive DC bus. The method can further include using the inverter controller to provide a consecutive sequence of gate turn on signals to the first through fourth switching devices. The inverter can further include a third pole including fifth and sixth switching devices linked in series between the positive and negative DC buses and linked at a common coupling point to a third of the inverter output lines, the fifth switching device linked to the positive DC bus. The step of using the inverter controller to provide a consecutive sequence of gate turn on signals can include using the inverter controller to provide a consecutive sequence of gate turn on signals to the first through sixth switching devices.

Additionally, the method can include repeating the steps of using the inverter controller to provide a first gate turn on signal to the first switching device; and presenting the voltage sensor signal via the display device for observation by a user for each of the inverter switching devices where, the voltage sensor is coupled to a gate terminal of a different one of the switching devices each time.

Other embodiments provide a method for use with an inverter and an inverter controller during a diagnostic procedure prior to normal inverter control. The inverter can include at least first and second poles where each pole includes a pair of switching devices linked in series between a positive DC rail and a negative DC rail, the first pole switches linked at a first common coupling point to a first inverter output line and including a first switching device linked to the positive DC bus, the second pole switches linked at a second common coupling point to a second inverter output line and including a second switching device linked to the negative DC bus, each switching device including a gate terminal, the controller linked to each gate terminal to control each switching device independently. The method can include the steps providing a display device for displaying at least one signal waveform, coupling a first current sensor to at least one of the first and second inverter output lines, the sensor generating a first sensor current signal, using the inverter controller to simultaneously provide a first gate turn on signal to the first switching device and a second gate turn on signal to the second switching device, and presenting the first sensor current signal via the display device for observation by a user. The step of coupling can include coupling the first current sensor to the first inverter output line, the method further including the step of coupling a second current sensor to the second inverter output line to generate a second sensor current signal and wherein the step of presenting includes simultaneously presenting each of the first and second sensor current signals via the display device. The first current sensor can be a feedback sensor. The method may further include the of identifying whether the first sensor current signal an unanticipated current signal.

The step of using the inverter controller to simultaneously provide a first gate turn on signal to the first switching device and a second gate turn on signal to the second switching device further can further comprise causing the inverter controller to simultaneously provide a third gate turn on signal to the first switching device and a fourth gate turn on signal to the second switching device.

The step of using the inverter controller to simultaneously provide a first gate turn on signal to the first switching device and a second gate turn on signal to the second switching device can further include selecting a selected pulse width. The first gate turn on signal can have a first pulse width equal to the selected pulse width and the second gate turn on signal can have a second pulse width equal to the selected pulse width.

To the accomplishment of the foregoing and related ends, the invention, then, comprises the features hereinafter fully described. The following description and the annexed drawings set forth in detail certain illustrative aspects of the invention. However, these aspects are indicative of but a few of the various ways in which the principles of the invention can be employed. Other aspects, advantages and novel features of the invention will become apparent from the following detailed description of the invention when considered in conjunction with the drawings.

### BRIEF DESCRIPTION OF THE SEVERAL VIEWS OF THE DRAWINGS

Fig. 1 is a schematic diagram of an exemplary power conversion assembly including an inverter that can be diagnosed according to the present invention;

Fig. 2 is a flow chart illustrating a method of diagnosing an inverter according to a first inventive embodiment; and

Fig. 3 is a flow chart illustrating a method of diagnosing an inverter according to a second inventive embodiment.

### DETAILED DESCRIPTION OF THE INVENTION

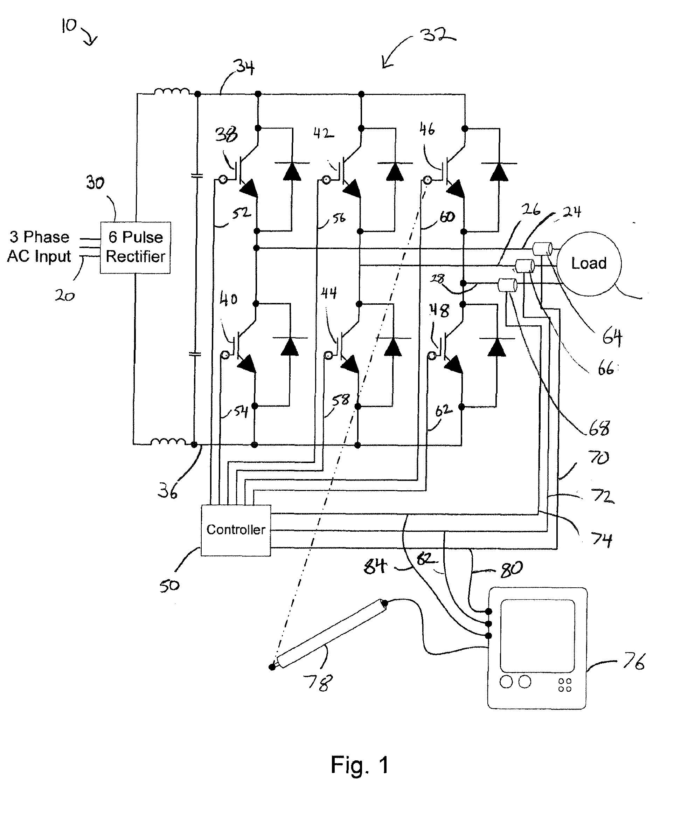

Referring now to the drawings wherein like reference numerals correspond to similar elements throughout the several views and, more specifically, referring to Fig. 1, the present invention will be described in the context of an exemplary power conversion system 10 that receives power from three AC supply lines collectively identified by numeral 20 and provides three phase AC power to a load 22 (e.g., a motor or a choke) via first, second and third AC output lines 24, 26 and 28, respectively. As shown, system 10 includes a rectifier 30 and an inverter 32. Rectifier 30 receives three phase AC input voltages on supply lines 20 and converts those AC voltages to a DC potential across positive and negative DC rails or buses 34 and 36, respectively. System 10 can be configured as a high-horsepower motor drive, which means that the DC buses 34 and 36 can carry high voltages and inverter 32 can provide large currents.

As well known in the power conversion arts, inverter 14 includes six switching devices 38, 40, 42, 44, 46 and 48 arranged in three device pairs. Each switching device includes an IGBT connected in parallel with a flyback diode. The switching devices in each pair are linked at a central node where each central node is provided as an inverter output. Switches 38 and 40 form a first pair and are connected to output line 24. Switches 42 and 44 form a second pair and are connected to output line 26. Switches 46 and 48 form a third pair and are connected to output line 28. Each pair of switches extends between positive and negative DC rails 34 and 36. Switches 38, 42, and 46 are connected to positive DC bus 34, and switches 40, 44 and 48 are connected to negative DC bus 36.

Referring yet again to Fig. 1, system 10 also includes a PWM controller 50 that is linked to inverter 32 for providing control signals to the subsets of switches that comprise the inverter 32. Controller 50 includes control lines 52, 54, 56, 58, 60, and 62 that are each connected to the gate of one of the switching devices 38, 40, 42, 44, 46 and 48, respectively. To provide enhanced control, inverter 32 includes current feedback sensors 64, 66, and 68 that are connected to output lines 24, 26, and 28, respectively. Current sensors 64, 66, and 68 are connected to controller 50 on feedback lines 70, 72 and 74, respectively. Current sensors 64, 66, and 68 can be Hall effect sensors and the like. As is well known in the art, controller 50 provides gate signals on control lines 52, 54, 56, 58, 60, and 62 to switching devices 38, 40, 42, 44, 46, and 48 to convert the DC voltage across DC bus 34 and 36 to three phase AC voltage that is delivered to load 22 on output lines 24, 26, and 28. As will be described below, a display device 76 can be used to view information about system 10 to diagnose inverter 32. Display device 76 includes display inputs 78, 80, 72, and 84. Display device 76 may be an oscilloscope and the like. Display inputs may be passive probes, differential voltage probes, current probes and the like. Accordingly, display inputs 78, 80, 72, and 84 can be used to probe various test points in system 10 in order to present information about system 10 on display device 76. Display input 78 may be used to probe control lines 52, 54, 56, 58, 60, and 62 to verify that the correct signals are being provided to switching devices 38, 40, 42, 44, 46 and 48. Additional display inputs may be used to simultaneously probe more than one of control lines 52, 54, 56, 58, 60, and 62. Display inputs 80, 82, and 84 may be used to monitor the current of the signals on output lines 24, 26 and 28. To monitor the current of output signals 24, 26, and 28, display inputs 80, 82, and 84 may be connected to feedback lines 70, 72 and 74 to monitor the voltage of the signals provided by the current sensors 64, 66, and 68 to controller 50. In another embodiment for use with an inverter that does not include current sensors that provide feedback to the controller, display inputs 80, 82 and 84 may be current probes that monitor output lines 24, 26, and 28.

If inverter 32 is both configured and operating correctly, controller 50 does not turn on both switching devices in a switching pair at the same time and, hence, no damaging current surges are created. If the inverter linkages are connected improperly (e.g., the gate signals are connected improperly) so that both switching devices in a switching pair are turned on at the same time, a short circuit will occur between the high voltage DC buses 34 and 36, which produces a large current surge that can irreparably damage power conversion system 32. Hence, inverter 32 should be diagnosed to determine whether inverter 32 is operating correctly before commencing normal inverter operation. For example, inverter 32 can be diagnosed at a production facility, upon commissioning, or after a repair procedure.

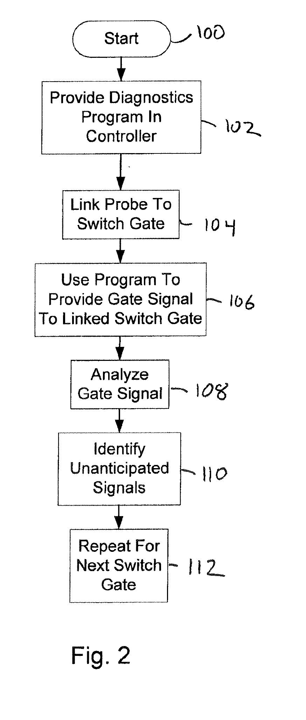

According to an embodiment of the present invention, Fig. 2 illustrates a method of diagnosing an inverter, such as inverter 32 of Fig. 1, and an inverter controller, such controller 50, prior to normal inverter operation. Following the start at step 100, a diagnostics program is provided to controller 50 at step102. The diagnostics program may be saved into memory on controller 50 to be selected by a user from a plurality of selectable controller programs or flashed into memory on controller 50. The diagnostics program is configured to cause controller 50 to provide gate control signals on control lines 52, 54, 56, 58, 60, and 62 as is discussed below. At step 104, display input 78 is linked to one of control lines 52, 54, 56, 58, 60, and 62 at a test point nearest the associated switching device 38, 40, 42, 44, 46 or 48 to determine whether controller 50 is providing the correct gate control signal to the linked control line. At step 106, the diagnostics program is run by controller 50 to provide a gate control signal to the control line to which display input 78 is linked. The gate control signal may be a single pulse or a plurality of pulses. The diagnostics program is configured to control controller 50 in response to user commands that are inputted through a human interface module connected to controller 50. Controller 50 can also be connected to a computer or other like device capable of controlling system 10. The diagnostics program is configured to allow a user to set a number of parameters for the gate control signal. The parameters that can be set are the selection of the switching device that is to be provided with a gate control signal, the number of pulses comprising the gate control signal, and the pulse width. The duration between pulses may also be a selectable parameter. Once the parameters have been inputted by the user, the user presses a start button on the human interface module that triggers controller 50 to provide a gate control signal as specified by the parameters (e.g., controller 50 provides a single 35 microsecond pulse to switching device 38; controller 50 provides two 70 microsecond pulses to switching device 48). The switching device selected by the user is the switching device connected to the control line to which display input 78 is linked.

At step 108, the provided gate control signal is analyzed by monitoring display device 76 to determine whether the gate control signal is being provided to the anticipated switching device. The anticipated switching device is the switching device associated with the control line that was linked to display input 78 during step 104. If the gate control signal is being provided to the anticipated switching device, display device 76 will show the presence of the gate control signal on the control line that is linked to display input 78. If no signal is detected by display input 78 when linked to the control line of the anticipated switching device or an unanticipated signal is detected on a control line that should not be receiving a gate control signal at that time, the unanticipated signal can be identified at step 110. At step 110, each of the other control lines may be probed while resending the gate control signal provided at step 106 to determine whether the provided gate control signal is being received by at least one unanticipated switching device. Alternatively at step 110, all six control lines can be simultaneously monitored on display device 76, or by additional display devices, while gate control signals are provided sequentially to each control line. At step 112, steps 104, 106, 108, and 110 may be repeated for each of the other switching devices until it has been verified that the gate control signals are being provided to the correct switching device or a fault condition with controller 50 or control lines 52, 54, 56, 58, 60, and 62 has been found. When a fault condition is indicated by the identification of unanticipated signals, inverter 32 or controller 50 may then be repaired and the method of Fig. 2 may be repeated to verify the repair.

In an alternative embodiment, the diagnostics program may be configured to automatically control controller 50 to sequentially provide gate control signals to the switching devices on the six control lines. When the gate control signals are provided in sequence, the diagnostics program may be configured to automatically provide the gate control signals or wait for a user prompt between each successive gate control signal to allow the user to link display input 78 to the next control line in the sequence. Alternatively, additional display inputs 78 may probe test points on control lines 52, 54, 56, 58, 60, and 62 to simultaneously monitor the signals on control lines 52, 54, 56, 58, 60, and 62. With multiple display inputs 78, the diagnostics program can control controller 50 to sequentially provide gate control signals on each of control lines 52, 54, 56, 58, 60, and 62 in a predetermined sequence. All six control lines may then be simultaneously monitored on display device 76, or by additional display devices, to analyze the provided gate control signals and identify any unanticipated signals.

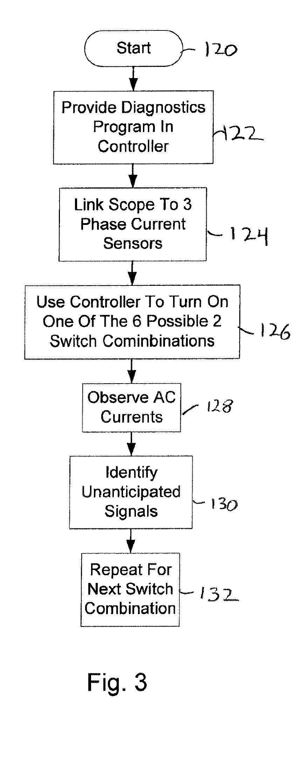

Fig. 3 illustrates a method of diagnosing an inverter and an inverter controller according to a further embodiment. The method of Fig. 3 is helpful when more information about the operation of system 20 is required, it is not possible to probe the control lines at test points near the switching devices, or there may be a fault condition between the test points and the switching devices. According to an embodiment of the present invention, Fig. 3 illustrates a method of diagnosing an inverter, such as inverter 32 of Fig. 1, and an inverter controller, such controller 50, prior to normal inverter operation. Following the start at step 120, a diagnostics program is provided to controller 50 at step122. The diagnostics program may be saved into memory on controller 50 to be selected by a user from a plurality of selectable controller programs or flashed into memory on controller 50. The diagnostics program is configured to cause controller 50 to provide gate control signals on control lines 52, 54, 56, 58, 60, and 62 as is discussed below. At step 124, display inputs 80, 82, and 84 are linked to feedback lines 70, 72, and 74, respectively, to monitor the signals provided by the current sensors 64, 66, and 68 that sense the current on output lines 24, 26, and 28. Alternatively, display inputs 80, 82, and 84 may be Hall effect sensors that directly monitor the current on output lines 24, 26, and 28. The voltages are output lines 24, 26, and 28 may also be monitored. At step 126, the diagnostics program is run by controller 50 to provide gate control signals to the control line to which display input 78 is linked. The diagnostics program is configured to control controller 50 in response to user commands that are inputted through the human interface module connected to controller 50. Controller 50 can also be connected to a computer or other like device capable of controlling system 10. The diagnostics program is configured to allow a user to set a number of parameters for the gate control signals. The parameters that can be set are the selection of the two switching devices that are to be provided with a gate control signals, the number of pulses comprising each of the gate control signals, and the pulse width. The two switching devices are switched on in order to produce one of six possible current states produced when two switches from different poles and connected to different voltage inputs are switched on simultaneously (i.e., I out of U and into V, I out of U and into W, I out of V and into U, I out of V and into W, I out of W and into U, and I out of W and into V). These current states are produced by six corresponding switch combinations. Providing two pulses allows the user to evaluate the ability of the switching devices to robustly handle commutations when supplied with high operational voltages. The duration between pulses may also be a selectable parameter. Once the parameters have been inputted by the user, the user presses a start button on the human interface module that triggers controller 50 to provide gate control signals as specified by the parameters (e.g., controller 50 provides a single 35 microsecond pulse to switching device 38 while simultaneously providing a single 35 microsecond pulse to switching device 44; controller 50 provides two 35 microsecond pulses to switching device 40 while simultaneously providing two single 35 microsecond pulses to switching device 46). Controller 50 may be programmed to restrict the diagnosis program from turning on both switches in a switch pair and from providing more than two pulses per gate control signal. Limiting the pulse width and limited number of pulses ensures that even if two switches in a switch pair are turned on, the possibility of a catastrophic short circuit is minimized.

At step 128, the output currents resulting from the provided gate control signals are analyzed by monitoring display device 76 to observe whether the two anticipated switching devices are being switched on, the switching devices are operating correctly, the feedback sensors are operating correctly, and the entire system 10 is operating correctly. The anticipated switching devices are the two switching devices selected by the user in step 126. At step 130, unanticipated signals are identified and can provide information about why inverter 32 or controller 50 is not operating correctly. At step 132, steps 126, 128, and 130 may be repeated for each of the other remaining combinations of switching devices to observe all six of the corresponding current states. When a fault condition is indicated by the identification of unanticipated signals, inverter 32 or controller 50 may then be repaired and the method of Fig. 3 may be repeated to verify the repair.

In an alternate embodiment, the diagnosis program could be configured to cause controller 50 to provide anticipated waveforms on display device 76 that correspond to the signals that should be produced for comparison by the user. Furthermore, the methods of Figs. 2 and 3 can be adapted to be used with a multiple inverter system in order to evaluate pulse delay between master and slave.

One or more specific embodiments of the present invention have been described above. It should be appreciated that in the development of any such actual implementation, as in any engineering or design project, numerous implementation-specific decisions must be made to achieve the developers' specific goals, such as compliance with system-related and business related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Thus, the invention is to cover all modifications, equivalents, and alternatives falling within the spirit and scope of the invention as defined by the following appended claims.

To apprise the public of the scope of this invention, the following claims are made

## Claims

1. A method for use with an inverter and an inverter controller, the inverter including a set of inverter switching devices including at least first and second switching devices and inverter output lines, each switching device including a gate terminal, the controller linked to each gate terminal to control each switching device independently, the method for diagnosing inverter linkages and comprising the steps of:
during a diagnostic procedure prior to normal inverter control:
(i) providing a display device for displaying at least one signal waveform;
(ii) coupling one of a voltage sensor to the gate terminal of the first switching device and a current sensor to the inverter output line associated with the first switching device, the sensor generating a sensor signal;
(iii) using the inverter controller to provide a first gate turn on signal to the first switching device; and
(iv) presenting the sensor signal via the display device for observation by a user.

2. The method of claim 1 further including the step of using the inverter controller to provide a second gate turn on signal to the second switching device where the first and second turn on signals are provided to the first and second switching devices simultaneously.

3. The method of claim 2 wherein the inverter includes at least first and second poles, each pole including a pair of switching devices linked in series between positive and negative DC buses, the switches in each pair linked at a common node to one of the inverter output lines, the first and second poles including the first and second switching devices, the first switching device linked to one of a positive DC bus and a negative DC bus and the second switching device linked to the other of the positive and the negative DC buses and, wherein, the step of coupling one of a voltage sensor and a current sensor includes coupling a first current sensor to a first inverter output line associated with the first inverter switching device so that the first current sensor generates a first sensor current signal.

4. The method of claim 3 further including the steps of coupling a second current sensor to a second inverter output line so that the second current sensor generates a second sensor current signal and presenting the second sensor current signal via the display device for observation by a user, the first and second sensor current signals presented simultaneously.

5. The method of claim 4 further including the step of comparing the presented sensor current signals to anticipated current signals.

6. The method of claim 3 wherein the step of using the inverter controller to provide the first gate turn on signal includes using the controller to provide a first sequence of gate turn on signals to the first switching device and wherein the step of using the inverter controller to provide the second gate turn on signal includes using the controller to provide a second sequence of gate turn on signals to the second switching device wherein each of the first and second sequences includes at least two turn on signals.

7. The method of claim 1 wherein the step of coupling one of a voltage sensor and a current sensor includes coupling a voltage sensor to the gate terminal of the first switching device.

8. The method of claim 7 wherein the step of using the inverter controller to provide a first gate turn on signal to the first switching device includes using the controller to provide a first gate turn on signal having a predetermined pulse width.

9. The method of claim 8 wherein the step of using the inverter controller to provide a first gate turn on signal to the first switching device further includes using the controller to provide a second gate turn on signal to the first switching device that has a predetermined pulse width and that is separated from the first gate turn on signal by a predetermined interval.

10. The method of claim 1 wherein the step of using the inverter controller to provide a first gate turn on signal to the first switching device further includes using the controller to provide a separate gate turn on signal to each of the inverter switching devices in a consecutive sequence.

11. A method for use with an inverter and an inverter controller, the inverter including a set of inverter switching devices including at least first, second, third and fourth switching devices and inverter output lines, each switching device including a gate terminal, the controller linked to each gate terminal to control each switching device independently, the method for diagnosing inverter linkages and comprising the steps of:
during a diagnostic procedure prior to normal inverter control:
(i) providing a display device for displaying at least one signal waveform;
(ii) coupling a voltage sensor to the inverter at a location electrically linked to the gate terminal of a first switching device, the sensor generating a voltage sensor signal;
(iii) using the inverter controller to provide a first gate turn on signal to the first switching device; and
(iv) presenting the voltage sensor signal via the display device for observation by a user.

12. The method of claim 11 wherein the inverter includes at least first and second poles, the first pole including the first and second switching devices linked in series between a positive DC bus and a negative DC bus and linked at a common coupling point to a first of the inverter output lines and the second pole including the third and fourth switching devices linked in series between the positive and negative DC buses and linked at a common coupling point to a second of the inverter output lines, the first and third switching devices linked to the positive DC bus, the method further including using the inverter controller to provide a consecutive sequence of gate turn on signals to the first through fourth switching devices.

13. The method of claim 12 wherein the inverter further includes a third pole including fifth and sixth switching devices linked in series between the positive and negative DC buses and linked at a common coupling point to a third of the inverter output lines, the fifth switching device linked to the positive DC bus, the step of using the inverter controller to provide a consecutive sequence of gate turn on signals including using the inverter controller to provide a consecutive sequence of gate turn on signals to the first through sixth switching devices.

14. The method of claim 13 further including the step of repeating steps (iii) and (iv) for each of the inverter switching devices where, each time steps (iii) and (iv) are repeated, the voltage sensor is coupled to a gate terminal of a different one of the switching devices.

15. A method for use with an inverter and an inverter controller, the inverter including at least first and second poles where each pole includes a pair of switching devices linked in series between a positive DC rail and a negative DC rail, the first pole switches linked at a first common coupling point to a first inverter output line and including a first switching device linked to the positive DC bus, the second pole switches linked at a second common coupling point to a second inverter output line and including a second switching device linked to the negative DC bus, each switching device including a gate terminal, the controller linked to each gate terminal to control each switching device independently, the method for diagnosing inverter linkages and comprising the steps of:
during a diagnostic procedure prior to normal inverter control:
(i) providing a display device for displaying at least one signal waveform;
(ii) coupling a first current sensor to at least one of the first and second inverter output lines, the sensor generating a first sensor current signal;
(iii) using the inverter controller to simultaneously provide a first gate turn on signal to the first switching device and a second gate turn on signal to the second switching device; and
(iv) presenting the first sensor current signal via the display device for observation by a user.

16. The method of claim 3 wherein the step of coupling includes coupling the first current sensor to the first inverter output line, the method further including the step of coupling a second current sensor to the second inverter output line to generate a second sensor current signal and wherein the step of presenting includes simultaneously presenting each of the first and second sensor current signals via the display device.

17. The method of claim 16 wherein the step of using the inverter controller to simultaneously provide a first gate turn on signal to the first switching device and a second gate turn on signal to the second switching device further comprises causing the inverter controller to simultaneously provide a third gate turn on signal to the first switching device and a fourth gate turn on signal to the second switching device.

18. The method of claim 15, wherein the step of using the inverter controller to simultaneously provide a first gate turn on signal to the first switching device and a second gate turn on signal to the second switching device further comprises selecting a selected pulse width, wherein the first gate turn on signal has a first pulse width equal to the selected pulse width and the second gate turn on signal has a second pulse width equal to the selected pulse width.

19. The method of claim 15, wherein first current sensor is current a feedback sensor.

20. The method of claim 15 further comprising the step of identifying whether the first sensor current signal an unanticipated current signal.
